# EUROPEAN PATENT APPLICATION

(11) **EP 4 765 509 A1**
(43) Date of publication of application: **24.06.2026**
(21) Application number: 24875691.8
(22) Date of filing: 22.08.2024
(51) Int. Cl.: H01R 13/52

(54) **CONNECTOR, MODULE**

(30) Priority: 20.10.2023 JP 2023181315
(71) Applicant: HOSIDEN CORPORATION, Yao-shi, Osaka 581-0071 (JP)
(72) Inventor: SATO, Eiji, Yao-shi, Osaka 581-0071 (JP); KONDO, Hayato, Yao-shi, Osaka 581-0071 (JP); IWAKI, Toshikazu, Yao-shi, Osaka 581-0071 (JP)
(74) Representative: MERH-IP Matias Erny Reichl Hoffmann Patentanwälte PartG mbB
(86) International application number: PCT/JP2024/029731
(87) International publication number: WO 2025/083996

(57) **Abstract**

To provide a connector that can prevent entry of potting material into the connector through an engagement hole. The connector includes a housing and a terminal. The housing includes a first part supporting the terminal, and a second part positioned on one side in a first direction relative to the first part and including a receiving portion. The receiving portion is open on the one side in the first direction and includes a wall portion on one side in a second direction, the second direction being substantially perpendicular to the first direction. The wall portion extends upright in the first direction and includes an engagement hole that penetrates the wall portion in the second direction. The housing includes a setback portion on the other side in the first direction relative to the engagement hole. The setback portion includes a first end face facing the one side in the second direction, a setback surface continuous with the first end face and facing the other side in the first direction, and a first wall surface continuous with the setback surface and facing the one side in the second direction.

## Description

### [TECHNICAL FIELD]

The present disclosure relates to connectors and modules.

### [BACKGROUND ART]

Along with automation of manufacturing facilities, many sensor devices for automation are used. Some facilities require sensor devices to have special features, such as waterproof features and explosion-proof features. One way to implement waterproof and explosion-proof features is filling the inside of a sensor device with sealant. Patent Literature 1 describes a connector adapted for potting as a connector that is used inside such a sensor device by being mounted on a substrate.

### [PRIOR ART LITERATURE]

### [PATENT LITERATURE]

Patent Literature 1: Japanese Patent Application Laid Open No. 2017-69096

### [SUMMARY OF THE INVENTION]

### [PROBLEMS TO BE SOLVED BY THE INVENTION]

Patent Literature 1 describes a connector having a connector housing and a contact terminal, where the connector housing has a tubular wall portion which internally defines an air collecting portion, in which air that arises during curing of potting material will collect. The connector, however, is structured such that protrusions formed on an outer peripheral wall engage with engaging portions on a cable-side connector to keep the two connectors fit on each other, while the mating cable-side connector is structured such that it has engaging portions on the outer periphery of the connector housing when it fits on the connector. Accordingly, if the protrusions on the outer peripheral wall become buried in potting material, the cable-side connector cannot fit onto and remain fitted on the connector. Even if the protrusions are not buried in potting material, when potting material is injected close to the protrusions, it will interfere with the engaging portions of the cable-side connector and hinder the cable-side connector from fitting onto and remain fitted on the connector. In addition, the cable-side connector is large (in thickness) because the outer peripheral wall portion of the connector housing is placed between the engaging portion and the side of formation of the engaging portion. When the mating connector is large in size, a device that is used while being kept in a fitted state will require a large dead space. Hence, there is a need for a structure that provides the outer peripheral wall of the mating connector with an engaging portion in a protruding profile such that the connector receives the mating connector together with the engaging portion at the time of fitting. However, such a structure makes it necessary to provide the connector with an engagement hole for engagement with the engaging portion of the mating connector and also to prevent entry of potting material into the connector through the engagement hole.

An object of the present disclosure is therefore to provide a connector that can prevent entry of potting material into the connector through an engagement hole.

### [MEANS TO SOLVE THE PROBLEMS]

A connector according to the present disclosure includes a housing and a terminal.

The housing includes a first part supporting the terminal, and a second part positioned on one side in a first direction relative to the first part and including a receiving portion.

The receiving portion is open on the one side in the first direction and includes a wall portion on one side in a second direction, the second direction being substantially perpendicular to the first direction.

The wall portion extends upright in the first direction and includes an engagement hole that penetrates the wall portion in the second direction.

The housing includes a setback portion on the other side in the first direction relative to the engagement hole.

The setback portion includes a first end face facing the one side in the second direction, a setback surface continuous with the first end face and facing the other side in the first direction, and a first wall surface continuous with the setback surface and facing the one side in the second direction.

### [EFFECTS OF THE INVENTION]

The connector according to the present disclosure can prevent entry of potting material into the connector through the engagement hole.

### [BRIEF DESCRIPTION OF THE DRAWINGS]

FIG. 1 is a perspective view showing a general structure of a connector in a first embodiment.
FIG. 2 is partial magnified sectional views of a prior art connector and the connector in the first embodiment, FIG. 2A showing a partial magnified sectional view of the prior art connector, and FIG. 2B showing a partial magnified sectional view of the connector in the first embodiment.
FIG. 3 is a perspective view showing a general structure of a connector in a second embodiment.
FIG. 4 is a perspective view of a module and a mating connector in a first example as seen from a first perspective.
FIG. 5 is a perspective view of the module and the mating connector in the first example as seen from a second perspective.
FIG. 6 is an exploded perspective view of the module in the first example (prior to injection of sealant) as seen from the first perspective.
FIG. 7 is an exploded perspective view of the module in the first example (prior to injection of sealant) as seen from the second perspective.
FIG. 8 is an exploded perspective view of a connector in the first example as seen from the first perspective.
FIG. 9 is an exploded perspective view of the connector in the first example as seen from the second perspective.
FIG. 10 is partial magnified sectional views illustrating the presence or absence of protruding portions and variations of the structure of a setback portion, FIG. 10A showing the case of forming protruding portions and a setback portion upper surface, FIG. 10B showing the case of forming a setback portion upper surface while omitting protruding portions, and FIG. 10C showing the case of omitting the protruding portions and the setback portion upper surface.
FIG. 11 is an exploded perspective view of the mating connector in the first example as seen from the first perspective.
FIG. 12 is an exploded perspective view of the mating connector in the first example as seen from the second perspective.

### [DETAILED DESCRIPTION OF THE EMBODIMENTS]

Embodiments of the present disclosure are now described in detail. Components with the same function are denoted with the same reference characters and overlapping description is omitted.

In the description, a direction in which a connector and a mating connector are inserted and extracted for retention of fitting and release is referred to as a first direction (Z-direction). One side in the first direction is referred to as Z1 side and the other side in the first direction is referred to as Z2 side. They are indicated in the diagrams. As will be described in more detail later, a second direction (Y-direction) substantially perpendicular to the first direction (Z-direction) and a third direction (X-direction) substantially perpendicular to both the first and the second directions are also used in the description. One side in the second direction is referred to as Y1 side and the other side in the second direction is referred to as Y2 side. One side in the third direction is referred to as X1 side and the other side in the third direction is referred to as X2 side. They are indicated in the diagrams.

### [First embodiment]

### <First technical feature>

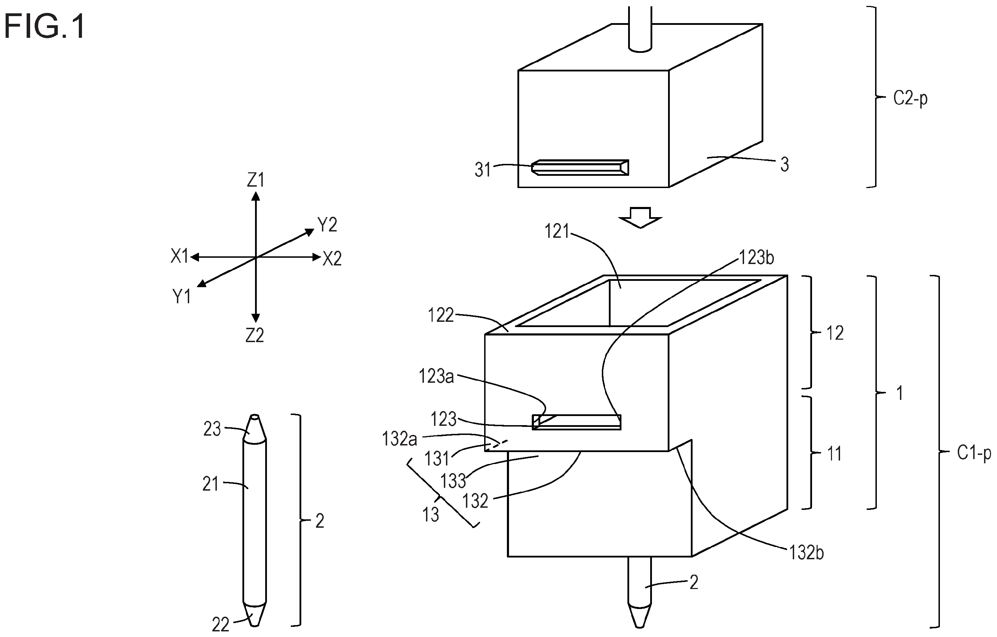

Referring to FIG. 1, a first technical feature provided by the connector in a first embodiment of the present disclosure is described.

As shown in this diagram, a connector C1-p in this embodiment includes a housing 1 and a terminal 2. The housing 1 includes a first part 11 and a second part 12. The first part 11 supports the terminal 2. The second part 12 is positioned on one side in the first direction (on the Z1 side in this diagram) relative to the first part 11, and includes a receiving portion 121.

The receiving portion 121 is open on one side in the first direction (the Z1 side) and includes a wall portion 122 on one side (the Y1 side) in the second direction, which is substantially perpendicular to the first direction (Z-direction). In the example of this diagram, it also includes wall portions 122 on the Y2, X1, and X2 sides in addition to the Y1 side.

The wall portion 122 extends upright in the first direction (Z-direction), and includes an engagement hole 123 that penetrates the wall portion 122 in the second direction (Y-direction).

The housing 1 includes a setback portion 13 on the other side (the Z2 side) in the first direction relative to the engagement hole 123.

The setback portion 13 includes a first end face 131 facing one side in the second direction (the Y1 side), a setback surface 132 continuous with the first end face 131 and facing the other side in the first direction (the Z2 side), and a first wall surface 133 continuous with the setback surface 132 and facing one side in the second direction (the Y1 side).

A mating connector C2-p is connected with the connector C1-p (described in more detail later).

### <Effects provided by the first technical feature>

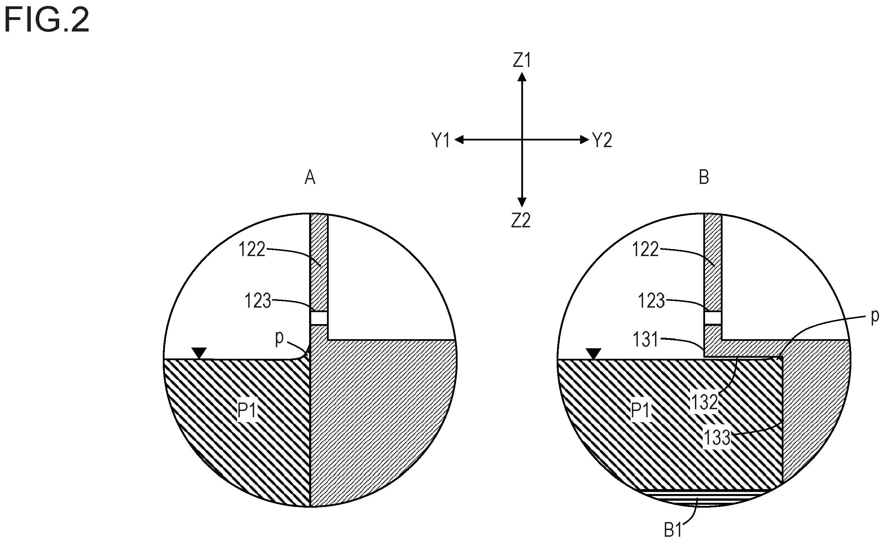

The connector C1-p is mounted on a substrate and accommodated in an inner space of an enclosure (not illustrated) together with the substrate. Sealant is injected into the inner space of the enclosure to fix the substrate and the connector C1-p. Here, assuming a connector without the setback portion 13, such as shown in FIG. 2A, it may give rise to the following issues.

As shown in FIG. 2A, the amount of sealant P1 injected is process-controlled so that a controlled upper height of its level (indicated by the black down-pointing triangle in the diagram) is lower than the engagement hole 123. However, since the sealant P1 is fluid material that is in sol form until it is cured with UV radiation, heating, or the like, the sealant P1 will climb up the wall surface of the housing 1 due to the action of surface tension, causing a rise p of the level.

When the level is immediately below the engagement hole 123 of the connector, the rise p of the level due to surface tension causes the sealant P1 to enter the receiving portion 121 through the engagement hole 123, which can lead to a poor contact with the mating connector C2-p due to adhesion of the sealant P1 to the terminal 2, or hinder a body 3 of the mating connector C2-p from being inserted into the receiving portion 121 due to interference of the sealant P1 that has entered the receiving portion 121.

This issue is not easy to address because the height of the rise p varies with the surface condition of the housing 1, the characteristics of the sealant P1, and the surrounding environment (such as temperature and humidity).

In order to prevent this issue in the prior example (FIG. 2A), it is necessary to secure a sufficient distance in the first direction (Z-direction) between the controlled upper height of the level of the sealant P1 and the engagement hole 123, also considering the variations in the height of the rise p. However, if the controlled upper height of the level of the sealant P1 is too low, electronic components or the like mounted on the substrate can be exposed, rather than being buried in the sealant P1. By contrast, when a dimension of the connector in the first direction (Z-direction) is increased, there would be no need to lower the controlled upper height of the level of the sealant P1; however, a larger dimension of the connector in the first direction (Z-direction) would increase the size of the enclosure and in turn of the entire device as well.

In the case of the connector C1-p having the setback portion 13 shown in FIG. 2B, when the controlled upper height of the level of the sealant P1 is set on the Z2 side relative to the setback surface 132, the rise p will occur against the first wall surface 133 and the setback surface 132. This is because the setback portion 13 allows a longer creepage distance from the level of the sealant P1 to the engagement hole 123.

This can prevent the rise p from occurring near the engagement hole 123 (the first end face 131), thus eliminating the necessity to lower the controlled upper height of the level or increase the size of the connector C1-p in the Z-direction considering the variations in the height of the rise p.

### <Second technical feature>

With continuing reference to FIG. 1, a second technical feature provided by the connector in the first embodiment of the present disclosure is described. As shown in this diagram, the engagement hole 123 includes an engagement hole first end 123a on one side (the X1 side) in the third direction, which is substantially perpendicular to the first direction (Z-direction) and the second direction (Y-direction), and an engagement hole second end 123b on the other side in the third direction (the X2 side).

The setback surface 132 includes a setback surface first end 132a on one side in the third direction (the X1 side), and a setback surface second end 132b on the other side in the third direction (the X2 side).

The setback surface first end 132a is positioned on one side in the third direction (the X1 side) relative to the engagement hole first end 123a, while the setback surface second end 132b is positioned on the other side in the third direction (the X2 side) relative to the engagement hole second end 123b.

Although the example of this diagram includes a single engagement hole 123, what is mentioned above also applies when there are multiple engagement holes 123. The multiple engagement holes 123 have engagement hole first ends 123a, respectively, and the setback surface first end 132a is positioned on one side in the third direction (the X1 side) relative to any of the engagement hole first ends 123a. Likewise, the multiple engagement holes 123 have engagement hole second ends 123b, respectively, and the setback surface second end 132b is positioned on the other side in the third direction (the X2 side) relative to any of the engagement hole second ends 123b.

### <Effects provided by the second technical feature>

The setback surface 132 (regardless of whether there is a single engagement hole 123 or multiple engagement holes 123) includes the setback surface first end 132a positioned further on the X1 side than the farthest end of the engagement hole 123 on the X1 side, and the setback surface second end 132b positioned further on the X2 side than the farthest end of the engagement hole 123 on the X2 side. As a result, the creepage distance from the level of the sealant P1 to the engagement hole 123 becomes long compared to a connector not including this feature. Hence, a rise p occurring at a location without the setback portion 13 can be hindered from flowing to the first end face 131 side and entering the engagement hole 123.

### [Second embodiment]

### <Third technical feature>

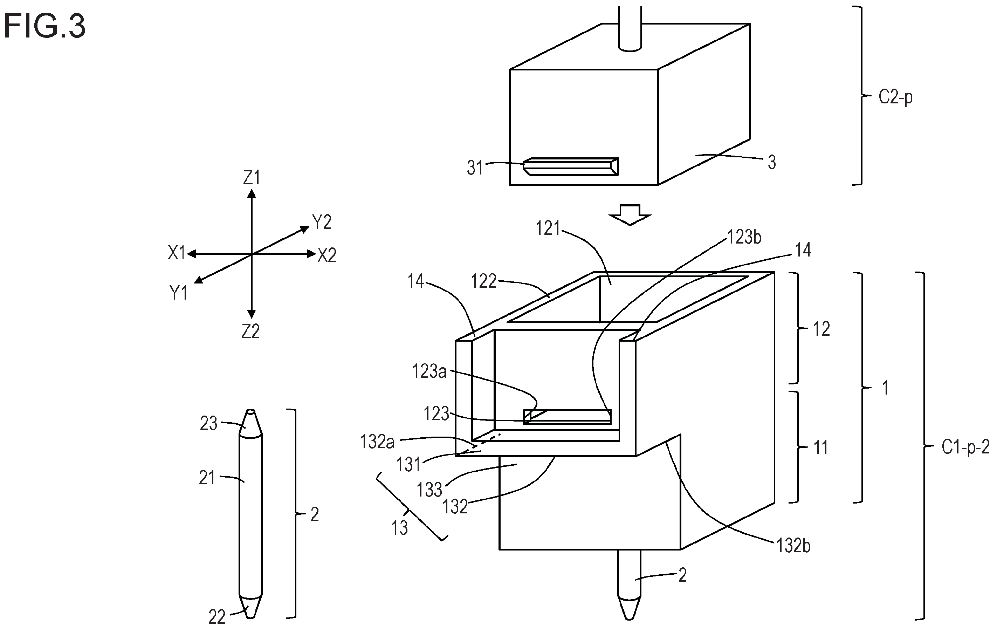

Referring to FIG. 3, a third technical feature provided by the connector in a second embodiment of the present disclosure is described. As shown in this diagram, the first end face 131 of a connector C1-p-2 in this embodiment is on one side in the second direction (the Y1 side) relative to the engagement hole 123 (the first end face 131 protrudes). The housing 1 includes a protruding portion 14 on one side in the third direction (the X1 side) relative to the engagement hole first end 123a and a protruding portion 14 on the other side in the third direction (the X2 side) relative to the engagement hole second end 123b, the protruding portions 14 being extended from the setback portion 13 to one side in the first direction (the Z1 side).

The other components are the same as those of the connector C1-p in the first embodiment.

### <Effects provided by the third technical feature>

By positioning the first end face 131 of the setback portion 13 on one side in the second direction (the Y1 side) relative to the engagement hole 123 (by making the first end face 131 protrude), the creepage distance from the level of the sealant P1 to the engagement hole 123 can be further increased. Moreover, by including the protruding portions 14, the sealant P1 can be hindered from reaching the engagement hole 123 even if the sealant P1 flows over the setback surface 132 from the setback surface first end 132a or the setback surface second end 132b.

There is also an advantage of easy production since the geometry including the first end face 131, the protruding portions 14, and the engagement hole 123 in this embodiment can be molded as an integral piece with the same Y-direction core of an injection molding die.

### <Fourth technical feature>

Referring to FIGs. 1 and 3, a fourth technical feature provided by the connector C1-p, C1-p-2 in the first and second embodiments of the present disclosure will be described. As shown in the diagrams, the terminal 2 includes a body portion 21, a connecting portion 22, and a tip portion 23.

The body portion 21 is held in the first part 11. The connecting portion 22 is on the other side in the first direction (the Z2 side) relative to the body portion 21 and is electrically connected with an electrode formed on a substrate disposed on the other side in the first direction (the Z2 side) relative to the housing 1. The tip portion 23 is on one side in the first direction (the Z1 side) relative to the body portion 21, part of the tip portion 23 being disposed in the receiving portion 121.

### <Effects provided by the fourth technical feature>

Since the connector C1-p, C1-p-2 is a vertical connector such that the receiving portion 121 of the housing 1 is open to the Z1 side and the connector is mounted on a substrate first surface B1a of a substrate B1, the mating connector C2-p can be inserted from the Z1 side and fitted into and kept fitted with the connector C1-p, C1-p-2. Thus, even if the sealant P1 is injected around the connector C1-p, C1-p-2, retention of fitting between the connector C1-p, C1-p-2 and the mating connector C2-p is not hindered as long as the sealant P1 does not enter the receiving portion 121.

### <Fifth technical feature>

Referring to FIGs. 1 and 3, a fifth technical feature provided by the connector C1-p, C1-p-2 in the first and second embodiments of the present disclosure will be described. The receiving portion 121 accommodates and holds at least part of the mating connector C2-p when the connector C1-p, C1-p-2 is fitted with the mating connector C2-p, and the engagement hole 123 engages with an engaging portion 31 of the mating connector C2-p when the connector C1-p, C1-p-2 is fitted with the mating connector C2-p.

### <Effects provided by the fifth technical feature>

For example, given a prior example that is designed so that the mating connector covers and fits on the connector (for example, Patent Literature 1), the conventional connector will include an engaging protrusion on the outer periphery of the housing, and the body of the conventional mating connector will have a locking portion that is positioned on the outer side of the housing when the mating connector is kept fitted on the conventional connector.

In the case of this example, it is possible that sealant is injected at the location of the locking portion and the locking portion interferes with the sealant to prevent fitting. Alternatively, it is necessary to lower the controlled upper height of the level of the sealant or to increase the Z-direction dimension of the connector so that the level is at a height at which it does not interfere with the locking portion.

By the virtue of the fifth technical feature provided by the connector C1-p, C1-p-2, the engagement hole 123 is able to retain a state of fitting between the connector C1-p (C1-p-2) and the mating connector C2-p by engaging with the engaging portion 31 on the body 3 of the mating connector C2-p. Accordingly, problems inherent in the design where the mating connector covers and fits on the connector do not arise.

### <Sixth technical feature>

Referring to FIG. 2B, a sixth technical feature provided by a module including the connector C1-p, C1-p-2 in the first and second embodiments of the present disclosure is described below. The module according to the present disclosure is formed from an enclosure (not illustrated), the connector C1-p (C1-p-2), the substrate B1, and the sealant P1.

The enclosure contains the connector C1-p of the first embodiment or the connector C1-p-2 of the second embodiment and the substrate B1 in an inner space.

As shown in FIG. 2B, the sealant P1 is injected into the inner space of the enclosure, where the level of the sealant P1 (the black down-pointing triangle in the diagram) is on one side in the first direction (the Z1 side) relative to the substrate B1 and on the other side in the first direction (the Z2 side) relative to the setback surface 132.

While FIG. 2B illustrates the features of the connector C1-p in the first embodiment, the positional relationship between the substrate B1, the setback surface 132, and the level of the sealant P1 is the same with the connector C1-p-2 of the second embodiment.

### <Effects provided by the sixth technical feature>

The module including the connector C1-p (C1-p-2) can achieve waterproof features or explosion-proof features by means of the sealant P1. When the module is provided with explosion-proof features, the connector C1-p (C1-p-2) can be electrically connected with an external device via a harness (an example of the mating connector). For example, in a case where the external device is a power supply unit, the power supply unit can also be provided with explosion-proof features, so that replacement of the power supply unit is possible with the module left attached in a hazardous area.

The components of the above-described embodiments may be combined with each other unless they are incompatible. The material, shape, dimensions, number, and arrangement of the components in different aspects of the embodiments mentioned above are examples and may be modified in design as desired if similar functionality can be attained.

### [EXAMPLE]

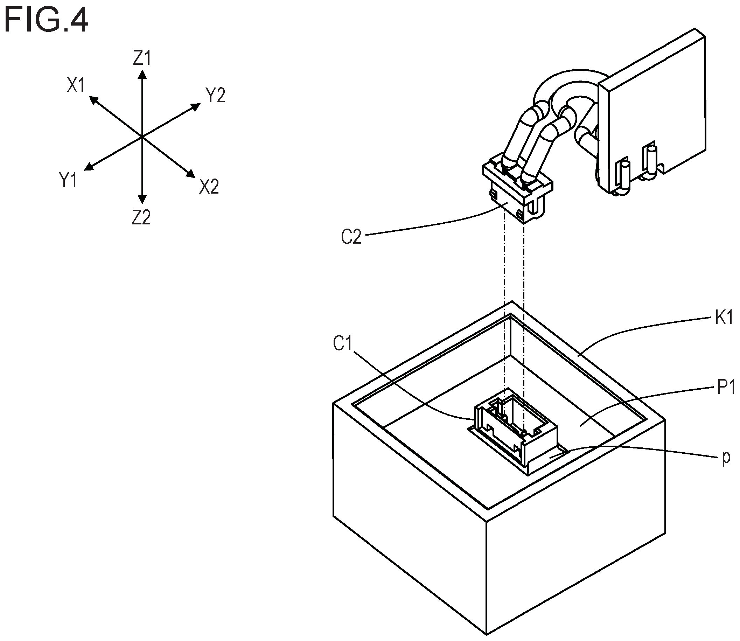

A connector, a module, and a mating connector as a first example will be described below with reference to FIGs. 4 to 12, as a detailed example of design of the connector, the module, and the mating connector of the embodiments described above.

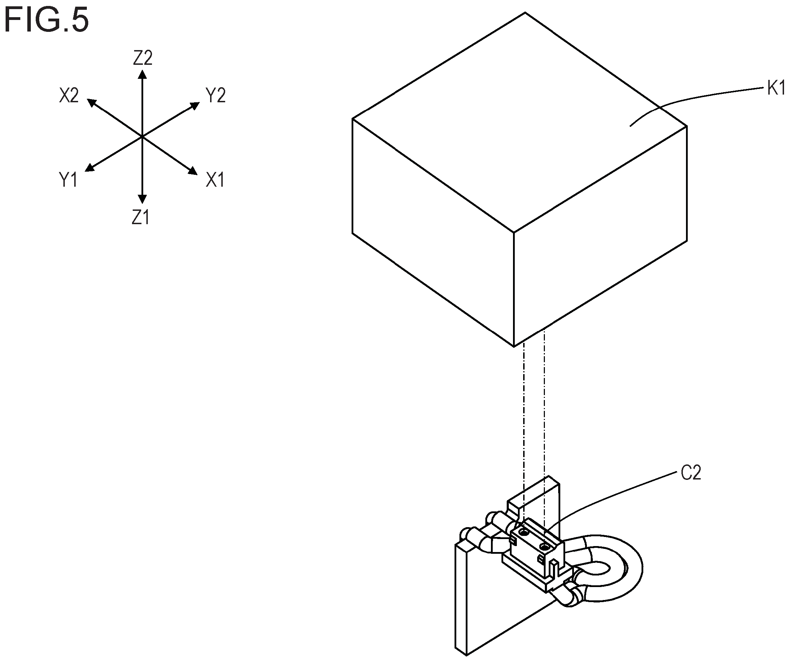

As shown in FIGs. 4 and 5, the module in this example is a device that includes an enclosure K1, sealant P1, and a connector C1, and is connected to a mating connector C2.

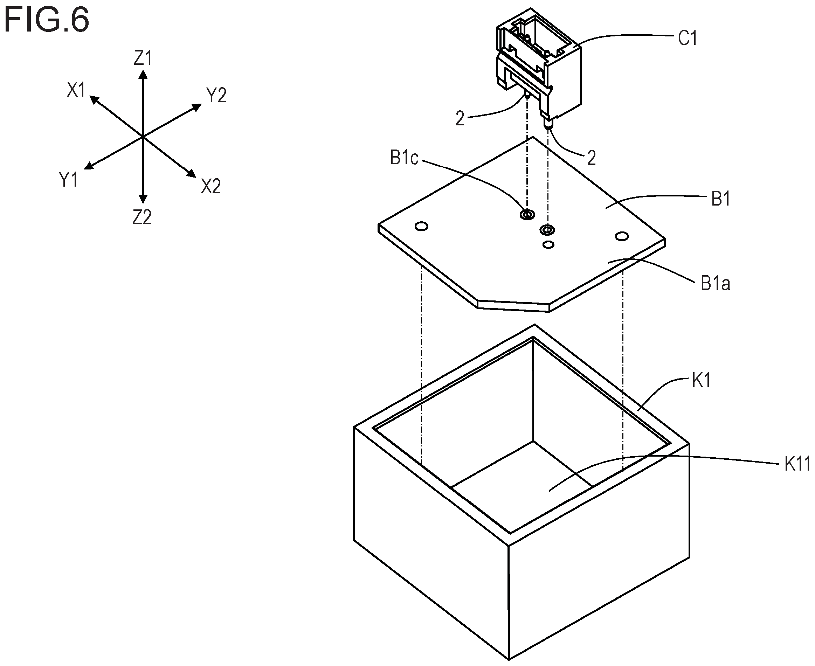

The enclosure K1 can be made of insulating material and includes an inner space K11 as shown in FIG. 6. The inner space K11 houses the connector C1 together with the substrate B1. As illustrated in FIG. 4, the inner space K11 is filled with the sealant P1.

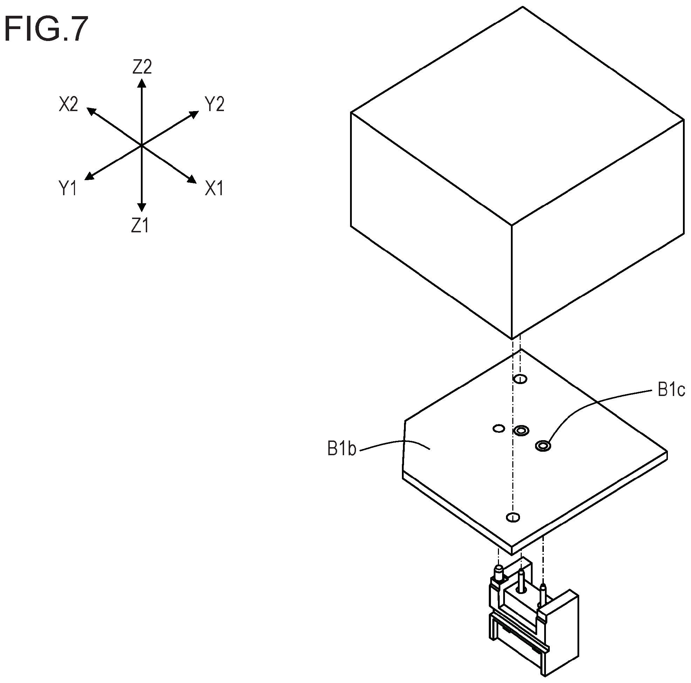

As shown in FIGs. 6 and 7, the connector C1 is mounted on the substrate B1 from the first direction (Z-direction) to be used. In this example, the connector C1 is disposed on the substrate B1 on one side in the first direction (the Z1 side).

The substrate B1 includes the substrate first surface B1a, which is a surface on one side in the first direction (the Z1 side), a substrate second surface B1b, which is a surface on the other side in the first direction (the Z2 side), and an electrode B1c. The substrate B1 is disposed with the connector C1 mounted on the substrate first surface B1a. The electrode B1c is a through-hole electrode that is electrically connected through the substrate first surface B1a and the substrate second surface B1b in a case where the connecting portion of the terminal 2 of the connector C1 is a straight terminal type, and is a surface electrode formed on the substrate first surface B1a in a case where the connecting portion of the terminal 2 of the connector C1 is a surface mounting type. The substrate B1 is a two-layer substrate consisting of two layers: the substrate first surface B1a and the substrate second surface B1b, but it may also be a multilayer substrate with three or more layers or may be a rigid substrate or a flexible substrate, for example.

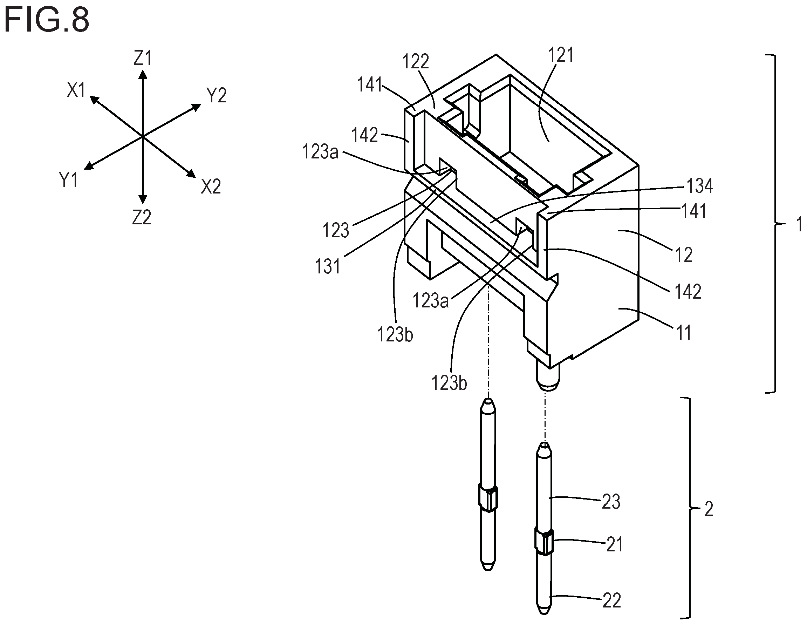

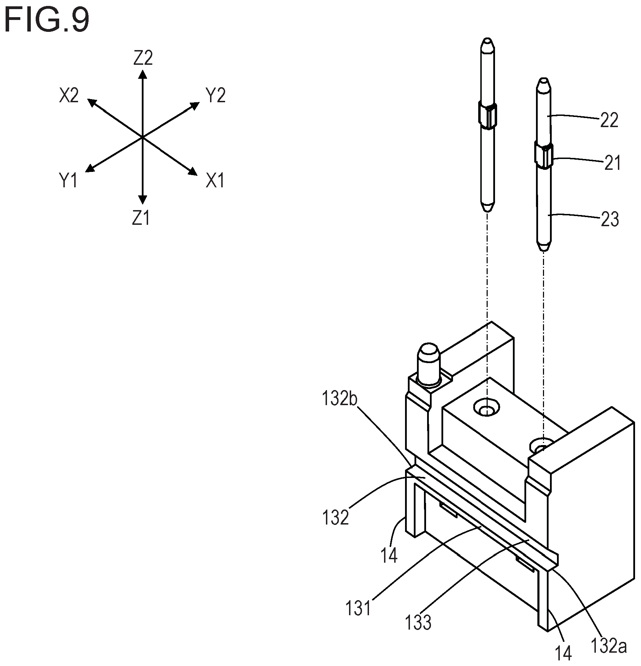

As shown in FIGs. 8 and 9, the connector C1 includes the housing 1 and at least one terminal 2 (two terminals 2 in this example).

The housing 1 is made of insulating material and includes the first part 11 and the second part 12. The first part 11 supports the terminal 2. The second part 12 is disposed on the Z1 side of the first part 11 and includes the receiving portion 121, the receiving portion 121 including the wall portion 122. The receiving portion 121 is open on the Z1 side. The wall portion 122 extends upright in the first direction (Z-direction). As depicted in the diagrams, the receiving portion 121 may be in a shape of a substantially square pole (a substantially rectangular parallelopiped).

The receiving portion 121 is not limited to the shape of a substantially square pole (a substantially rectangular parallelopiped) but may be of any shape. Accordingly, the wall portion 122 can be walls in the four directions, or if the receiving portion 121 is in the shape of a circular cylinder, can be in the shape of a circular cylinder. The wall portion 122 may also consist of combination of other shapes.

The wall portion 122 on one side in the second direction (the Y1 side) includes at least one engagement hole 123 (two engagement holes 123 in this example) that penetrates the wall portion 122 in the second direction (Y-direction).

Furthermore, the housing 1 includes the setback portion 13 on the Z2 side of the engagement holes 123. The setback portion 13 includes the first end face 131 facing one side in the second direction (the Y1 side), the setback surface 132 continuous with the first end face 131 and facing the other side in the first direction (the Z2 side), and the first wall surface 133 continuous with the setback surface 132 and facing one side in the second direction (the Y1 side).

The engagement hole 123 may include the engagement hole first end 123a on the X1 side and the engagement hole second end 123b on the X2 side; the setback surface 132 may include the setback surface first end 132a on the X1 side and the setback surface second end 132b on the X2 side; the setback surface first end 132a may be positioned on the X1 side relative to all of the engagement hole first ends 123a; and the setback surface second end 132b may be positioned on the X2 side relative to all of the engagement hole second ends 123b.

In addition, the first end face 131 may be on the Y1 side relative to the engagement hole 123 (the first end face 131 may protrude), such that a setback portion upper surface 134 may be formed on the opposite side of the setback surface 132.

The housing 1 may also include the protruding portion 14 on one side in the third direction (the X1 side) relative to the engagement hole first end 123a, and the protruding portion 14 on the other side in the third direction (the X2 side) relative to the engagement hole second end 123b, the protruding portions 14 being extended from the setback portion 13 to one side in the first direction (the Z1 side).

The protruding portion 14 on the X1 side may be positioned on the X1 side relative to the engagement hole first ends 123a of all the engagement holes 123, and the protruding portion 14 on the X2 side may be positioned on the X2 side relative to the engagement hole second ends 123b of all the engagement holes 123. Each protruding portion 14 may include a protruding portion first end 141 on the Z1 side, and the protruding portion first end 141 may be positioned on the Z1 side relative to the engagement hole 123.

Each protruding portion 14 may include a protruding portion second end 142 on the Y1 side, and the protruding portion second end 142 may be at the same position as the first end face 131 in the second direction (Y-direction).

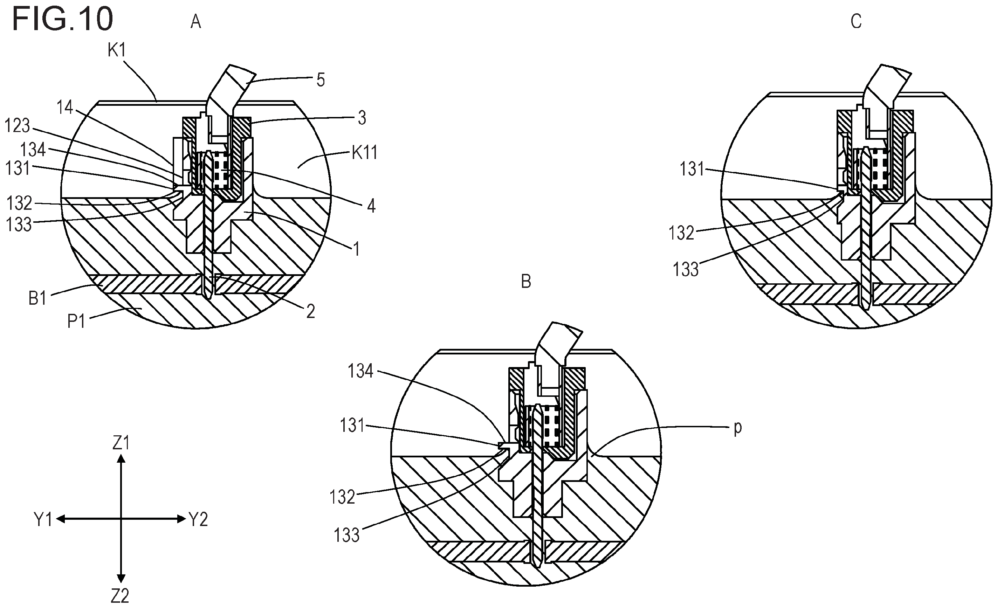

As shown in FIGs. 10B and 10C, the protruding portions 14 and the setback portion upper surface 134 may be omitted.

The first end face 131 may be a plane parallel to the ZX-plane or may be inclined. The setback surface 132 may be a plane parallel to the XY-plane or may be inclined. The first wall surface 133 may be a plane parallel to the ZX-plane or may be inclined. The setback portion upper surface 134 may be a plane parallel to the XY-plane or may be inclined.

As shown in FIGs. 8 and 9, the terminal 2 is formed of electrically conductive material such as a metal plate, and includes the body portion 21, the connecting portion 22, and the tip portion 23. The body portion 21 may be held in the first part 11 of the housing 1. The connecting portion 22 extends to the Z2 side relative to the body portion 21 and can be electrically connected with an electrode formed on the substrate B1 disposed on the Z2 side of the housing 1. The tip portion 23 extends to the Z1 side relative to the body portion 21, and a part of the tip portion 23 can be configured to be positioned within the receiving portion 121 of the housing 1.

When there are two or more terminals 2, the terminals 2 can be spaced from each other in the second direction (Y-direction) and/or in the third direction (X-direction). Also, the creepage distance of the housing 1 between neighboring terminals 2 can be sufficiently long so that the terminals 2 are positioned at a distance that satisfies explosion-proof features.

The connecting portion 22 of the terminal 2 may be of a straight terminal type extending to the Z2 side, or of a surface mounting terminal type extending to the Z2 side with the tip extending in the second direction (Y-direction) or the third direction (X-direction).

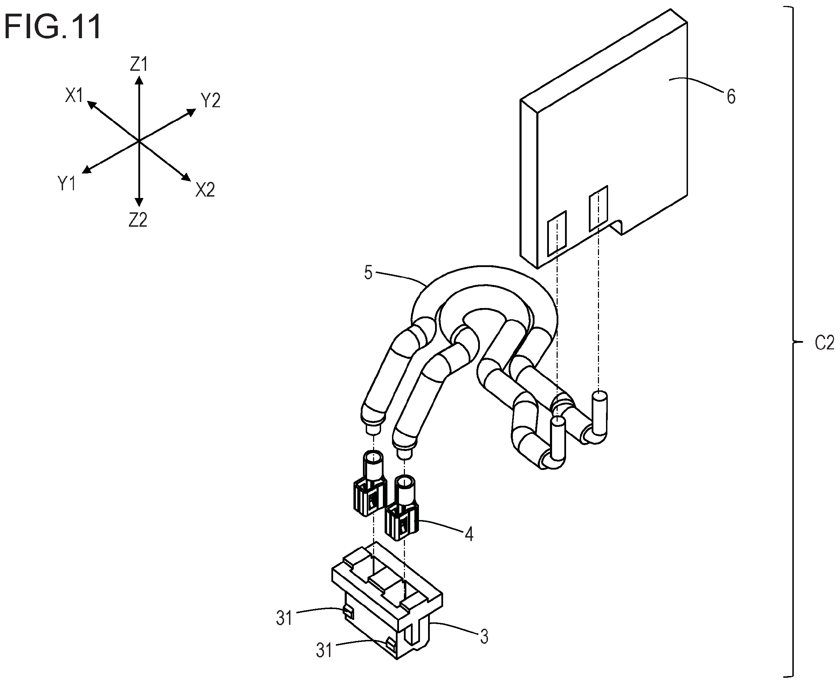

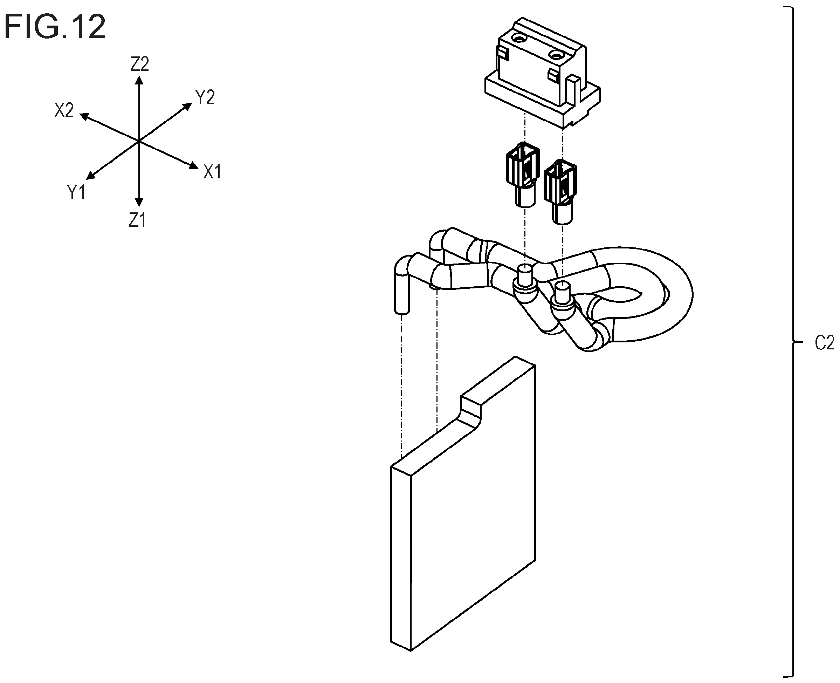

As shown in FIGs. 11 and 12, the mating connector C2 may include the body 3, at least one contact 4, and a wire 5.

The body 3 may be made of insulating material and include the engaging portion 31 protruding to the Y1 side. The contact 4 may be formed of electrically conductive material such as a metal plate, and may be electrically connected with the wire 5 and at least partially accommodated and held in the body 3.

At least part of the body 3 of the mating connector C2 may be accommodated and held in the receiving portion 121 of the housing 1 when the mating connector C2 is fitted in the connector C1, and the engaging portion 31 can be configured to engage with the engagement hole 123 so that fitting with the connector C1 is retained. The engaging portion 31 may be either of half lock type or full lock type. The diagrams show a half lock type with tapers both on the Z1 and Z2 sides.

The number of contacts 4 may be either equal to or smaller than the terminals 2. The contacts 4 may be configured to be electrically connected with an external device via the wire 5. For example, in a case where the external device is a power supply unit with a battery and a sensor unit is mounted on the substrate B1, the connector C1 can be a double-pole connector with two terminals, which is fit to and kept fitted with the mating connector C2 so that the sensor unit on the substrate B1 can be powered from the power supply unit.

### <Ways of assembling the connector and sealing the inside of the enclosure>

As shown in FIG. 8, the terminal 2 is inserted from the Z2 side of the first part 11 of the housing 1, and the body portion 21 of the terminal 2 is fixed by press fitting. At this point, the connecting portion 22 of the terminal 2 is exposed on the Z2 side of the housing 1, and the tip portion 23 sits in the receiving portion 121 of the housing 1 and exposed.

Next, as shown in FIG. 6, the connector C1 is mounted on the substrate first surface B1a of the substrate B1 by soldering, for example, and the at least one terminal 2 of the connector C1 establishes electrical connection with the electrode B1c. Next, the enclosure K1 is fixed in such a position that the inner space K11 is open in Z1-direction, and the substrate B1 with the connector C1 mounted thereon is disposed at a predefined position in the inner space K11 of the enclosure K1.

Sealant P1 is then injected into the inner space K11 as shown in FIG. 4. As shown in FIG. 10, the amount of sealant P1 injected is controlled so that the level of the sealant P1 is on the Z1 side relative to the substrate first surface B1a and on the Z2 side relative to the setback surface 132. Next, the sealant P1 is cured. The sealant P1 may be cured with heat when thermosetting resin is used, by UV radiation when UV curable resin is used, or in any other manner.

### <First modification>

The receiving portion 121 of the housing 1 of the connector C1 may be in the shape of a substantially circular cylinder. In that case, the second direction (Y-direction) is the normal direction passing through the center of the substantially circular cylinder, and the third direction (X-direction) is a direction parallel to the tangent to the substantially circular cylinder. The first end face 131 may also run 360° continuously along the outer periphery of the cylinder. In that case, the setback surface 132 will not include the setback surface first end 132a and the setback surface second end 132b. The first end face 131 may also be discontinuous in part of 360°. In that case, the setback surface 132 will include the setback surface first end 132a and the setback surface second end 132b.

### <Second modification>

The receiving portion 121 of the housing 1 of the connector C1 is not limited to being a circle or a square in the shape of its cross section parallel to the XY-plane, but may have a cross-sectional shape that combines an arc, a polygon, and the like.

### <Technical features and effects>

The connector C1 and the module that includes the connector C1 described in the example and modifications above at least have <the first to sixth technical features> described above and provide <the effects provided by the first to sixth technical features>.

### [INDUSTRIAL APPLICABILITY]

The present disclosure is applicable to electronic devices such as sensor devices that are used in, for example, plants and factories that require explosion-proof features.

## Claims

1. A connector comprising a housing and a terminal, wherein
the housing includes
a first part supporting the terminal, and
a second part positioned on one side in a first direction relative to the first part and including a receiving portion,
the receiving portion is open on the one side in the first direction and includes a wall portion on one side in a second direction, the second direction being substantially perpendicular to the first direction,
the wall portion extends upright in the first direction and includes an engagement hole that penetrates the wall portion in the second direction,
the housing includes a setback portion on the other side in the first direction relative to the engagement hole, and
the setback portion includes
a first end face facing the one side in the second direction,
a setback surface continuous with the first end face and facing the other side in the first direction, and
a first wall surface continuous with the setback surface and facing the one side in the second direction.

2. The connector according to Claim 1, wherein
the engagement hole includes
an engagement hole first end on one side in a third direction, the third direction being substantially perpendicular to the first direction and the second direction, and
an engagement hole second end on the other side in the third direction,
the setback surface includes
a setback surface first end on the one side in the third direction, and
a setback surface second end on the other side in the third direction,
the setback surface first end is positioned on the one side in the third direction relative to the engagement hole first end, and
the setback surface second end is positioned on the other side in the third direction relative to the engagement hole second end.

3. The connector according to Claim 1, wherein
the first end face is on the one side in the second direction relative to the engagement hole.

4. The connector according to Claim 1, wherein
the engagement hole includes
an engagement hole first end on one side in a third direction, the third direction being substantially perpendicular to the first direction and the second direction, and
an engagement hole second end on the other side in the third direction, and
the housing includes a protruding portion on the one side in the third direction relative to the engagement hole first end and a protruding portion on the other side in the third direction relative to the engagement hole second end, the protruding portions being extended from the setback portion to the one side in the first direction.

5. The connector according to Claim 1, wherein
the terminal includes a body portion, a connecting portion, and a tip portion,
the body portion is held in the first part,
the connecting portion is on the other side in the first direction relative to the body portion, and is electrically connected with an electrode formed on a substrate disposed on the other side in the first direction relative to the housing, and
the tip portion is on the one side in the first direction relative to the body portion, at least part of the tip portion being disposed in the receiving portion.

6. The connector according to Claim 1, wherein
the receiving portion accommodates and holds at least part of a mating connector when the connector is fitted with the mating connector, and
the engagement hole engages with an engaging portion of the mating connector when the connector is fitted with the mating connector.

7. A module comprising:
the connector according to Claim 1;
a substrate;
an enclosure containing the connector and the substrate in an inner space; and
sealant injected into the inner space, where a level of the sealant is on the one side in the first direction relative to the substrate and on the other side in the first direction relative to the setback surface.
